# DEMANDE DE BREVET EUROPEEN

(11) **EP 2 254 160 A2**
(43) Date de publication de la demande: **24.11.2010**
(21) Numéro de dépôt: 10162553.1
(22) Date de dépôt: 11.05.2010
(51) Int. Cl.: H01L 31/102, H01L 27/146

(54) **Photodiode a controle de charge d'interface par implantation et procede associe.**

(30) Priorité: 18.05.2009 FR 0953289
(71) Demandeur: STmicroelectronics SA, 92120 Montrouge (FR); STMicroelectronics (Crolles 2) SAS, 38920 Crolles (FR)
(72) Inventeur: Regolini, Jorge, 38190, BERNIN (FR); Pinzelli, Luc, 38100, GRENOBLE (FR)
(74) Mandataire: Delprat, Olivier

(57) **Abrégé**

Cette photodiode comprend une première couche dopée (2) et une deuxième couche dopée (3) présentant une face commune, au moins une tranchée d'isolation profonde (4) présentant une face contiguë avec la première couche dopée (2) et la deuxième couche dopée (3), une face libre de la deuxième couche dopée (3) étant en contact avec une couche conductrice (5).

Elle comprend une couche de protection (7) apte à générer une couche de charges négatives à l'interface avec d'une part la première couche dopée (2) et la deuxième couche dopée (3) et d'autre part la tranchée d'isolation profonde.

## Description

L'invention se rapporte au domaine des photodiodes et plus particulièrement aux photodiodes réalisées en matrices.

La technologie des photodiodes repose sur deux paramètres importants.

Le premier paramètre est la sensibilité de la photodiode qui représente la capacité de la photodiode à collecter des porteurs de charge photogénérés. Ce paramètre contrôle l'intensité du courant généré pour une illumination donnée.

Le deuxième paramètre est le courant d'obscurité qui représente le courant circulant dans la photodiode lorsque aucune lumière ne l'illumine. Ce paramètre contrôle la différence d'intensité du courant généré pour une différence d'illumination donnée.

Une partie plus ou moins importante des électrons générés dans la photodiode ne participent pas au photocourant car ils sont piégés par des défauts structuraux ou des zones de recombinaison. De même, dans le cas de capteurs matriciels à photodiodes, la réduction de taille crée des effets d'influence entre des photodiodes voisines, dégradant les performances de l'ensemble des diodes.

On pourra, à cet égard, se référer au document « Deep Trench isolation for crosstalk suppression in active pixel sensors with 1.7µm Pixel pitch », B. J. Park et al., Japanese Journal of Applied Physics, Vol 46, No.4B, 2007, pp. 2454-2457 qui décrit la réalisation de tranchées d'isolation profonde et leur utilisation dans les photocapteurs matriciels afin de limiter les effets de voisinage.

Cependant, les tranchées d'isolation profonde peuvent jouer un rôle similaire aux défauts structuraux ou centres de recombinaison. On rappelle que les centres de recombinaison détruisent les porteurs de charge en les combinant avec un porteur de charge opposée, par exemple en combinant un trou avec un électron.

En effet, les tranchées d'isolation profonde comprennent généralement un matériau isolant et sont réalisées dans un milieu semi-conducteur. Par ailleurs, une propriété inhérente aux interfaces Silicium/oxyde ou silicium/nitrure est de présenter une charge de surface positive apte à attirer les électrons photogénérés. On comprend alors que les tranchées d'isolation profonde agissent comme des pièges pour les électrons photogénérés.

Il est donc souhaitable de minimiser ou de supprimer le piégeage des électrons photogénérés au voisinage des murs d'isolation profonde.

Il existe également un besoin pour un dispositif de type photodiode dans lequel le piégeage des électrons photogénérés au voisinage des murs d'isolation profonde est minimisé ou supprimé.

Il est donc proposé, dans un mode de réalisation, une photodiode comprenant une première couche dopée et une deuxième couche dopée présentant une face commune, au moins une tranchée d'isolation profonde présentant une face contiguë avec la première couche dopée et la deuxième couche dopée, une face libre de la deuxième couche dopée étant en contact avec une couche conductrice.

Cette photodiode comprend en outre une couche de protection apte à générer des charges négatives à l'interface avec d'une part la première couche dopée et la deuxième couche dopée et d'autre part la tranchée d'isolation profonde.

La couche de protection peut être réalisée par implantation d'espèces de type dopant p.

La couche de protection peut être réalisée par implantation d'espèces choisies parmi le bore et l'indium.

La couche de protection peut comprendre également du carbone implanté.

Selon un autre aspect de l'invention, on définit un procédé de réalisation d'au moins une tranchée d'isolation profonde, chaque tranchée d'isolation profonde étant réalisée entre deux photodiodes réalisées à partir d'une structure comprenant une première couche dopée et une deuxième couche dopée présentant une face commune, une face libre de la deuxième couche dopée étant en contact avec une couche conductrice. Le procédé comprend des étapes au cours desquelles :
on forme une couche de protection en implantant une espèce à l'interface entre, d'une part, une première couche dopée et une deuxième couche dopée et d'autre part la tranchée d'isolation profonde, l'espèce implantée ayant la propriété de créer une couche de charge négative au contact du silicium dopé.

L'espèce implantée peut être une espèce de type dopant p.

L'espèce implantée peut être choisie parmi le bore et l'indium.

On peut implanter également du carbone à l'interface lors de la formation de la couche de protection.

On peut co-implanter au moins deux espèces différentes choisies parmi les espèces implantées.

D'autres buts, caractéristiques et avantages apparaîtront à la lecture de la description suivante donnée uniquement en tant qu'exemple non limitatif et faite en référence aux dessins annexés sur lesquels :
- la figure 1 illustre les principaux éléments d'une photodiode selon l'état de l' art ;
- la figure 2 illustre les principaux éléments d'une photodiode; avec couche de protection ; et
- la figure 3 illustre le procédé d'implantation associé à la réalisation d'une photodiode avec couche de protection.

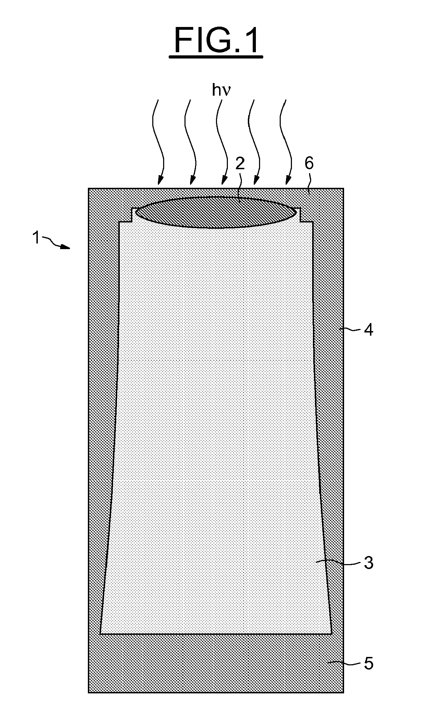

Sur la figure 1, on peut voir une photodiode selon l'état de l'art. La photodiode 1 comprend une ouverture sur un empilement de deux couches de dopages opposés, formant une diode. Une première couche 2 présente un dopage N tandis que la deuxième couche 3 présente un dopage P. Sous la deuxième couche 3 se situe une zone conductrice 5, pouvant être une couche de silicium, une couche de silicium dopé, ou une couche métallique.

La photodiode 1 ainsi décrite est généralement destinée à être intégrée dans un capteur matriciel. Il est alors nécessaire d'isoler une photodiode donnée des photodiodes voisines. Pour cela, des tranchées d'isolation profonde 4 sont formées pour séparer deux photodiodes immédiatement voisines. Les tranchées d'isolation profonde 4 (DTI ou « Deep trench isolation » en anglais) sont réalisées en matériau isolant.

Par ailleurs, la face extérieure de la photodiode se trouve protégée de l'extérieur par une couche de passivation 6, également en matériau isolant. A l'interface entre la première couche 2 et la deuxième couche 3 se crée une zone de charge d'espace dans laquelle le rayonnement électromagnétique incident peut être absorbé. L'absorption donne lieu alors à la création d'une paire électron-trou. L'électron et le trou migrent chacun dans une direction opposée sous l'effet du champ électrique régnant dans la zone de charge d'espace. Le déplacement des électrons et des trous photogénérés donne ainsi lieu à la création d'un courant photoélectrique.

Comme cela a été décrit précédemment, les tranchées d'isolation profonde 4 sont généralement réalisées en isolant de type oxyde ou nitrure qui présentent la propriété de générer une charge positive à l'interface avec un semi-conducteur. Dans le cas de la photodiode décrite sur la figure 1, une telle couche de charge positive peut engendrer un champ suffisant pour attirer et capturer les électrons photogénérés, diminuant d'autant le courant photoélectrique.

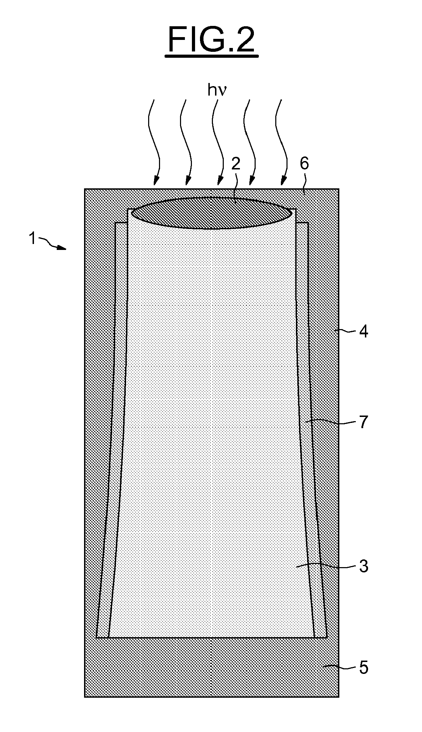

Il est proposé de réaliser une couche de protection 7 illustrée par la figure 2. Cette couche de protection 7 permet de créer une couche de charges négatives à l'interface avec la première couche 2 et la deuxième couche 3 afin de repousser les électrons photogénérés afin de diminuer les risques de capture.

La couche de protection 7 est créée par implantation ionique d'espèces dopantes de type p à l'interface entre d'une part, le silicium dopé de la première couche 2 et de la deuxième couche 3, et d'autre part, le diélectrique de la tranchée d'isolation profonde. Les ions implantés doivent rester localisés au niveau de l'interface afin de ne pas perturber le fonctionnement des zones actives. Pour cela, on implante également du carbone qui présente la propriété de minimiser la diffusion du bore et de l'indium (ou autre) dans le silicium. Ainsi, lors des étapes de recuits thermiques, les espèces implantées restent localisées au niveau de l'interface entre le silicium et les tranchées d'isolation profonde.

Les espèces implantées sont de dopants de type p et peuvent être notamment le bore ou l'indium ou autre.

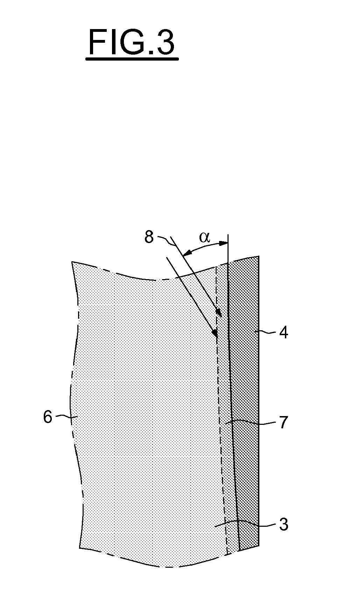

La figure 3 illustre l'implantation des espèces afin de former la couche de protection 7.

L'implantation a lieu avec un angle α par rapport à la normale à la surface des couches de silicium. L'angle α peut être compris entre 2° et 26°.

La dose est comprise entre 10¹¹ et 10¹³ at.cm⁻²

L'énergie d'implantation est comprise entre moins de 1keV et 25keV.

Une photodiode comprenant des tranchées d'isolation profonde voit ses caractéristiques améliorées en réalisant par implantation une couche de protection de façon qu'une zone de charge négative apparaisse à l'interface entre le silicium et la tranchée d'isolation profonde. En évitant la recombinaison des électrons photogénérés, la couche de protection permet d'améliorer le contraste, le courant d'obscurité, et l'intensité du courant photogénéré.

## Revendications

1. Photodiode comprenant une première couche dopée (2) et une deuxième couche dopée (3) présentant une face commune, au moins une tranchée d'isolation profonde (4) présentant une face contiguë avec la première couche dopée (2) et la deuxième couche dopée (3), une face libre de la deuxième couche dopée (3) étant en contact avec une couche conductrice (5),
**caractérisée en ce qu'**elle comprend une couche de protection (7) apte à générer une couche de charges négatives à l'interface avec d'une part la première couche dopée (2) et la deuxième couche dopée (3) et d'autre part la tranchée d'isolation profonde.

2. Photodiode selon la revendication 1, dans laquelle la couche de protection (7) est réalisée par implantation d'espèces de type dopant p.

3. Photodiode selon l'une des revendications 1 et 2, dans laquelle la couche de protection (7) est réalisée par implantation d'espèces choisies parmi le bore et l'indium.

4. Photodiode selon l'une quelconque des revendications 1 à 3, dans laquelle la couche de protection (7) comprend également du carbone implanté.

5. Procédé de réalisation d'au moins une tranchée (4) d'isolation profonde, chaque tranchée (4) d'isolation profonde étant réalisée entre deux photodiodes réalisées à partir d'une structure comprenant une première couche dopée (2) et une deuxième couche dopée (3) présentant une face commune, une face libre de la deuxième couche dopée (3) étant en contact avec une couche conductrice (5), **caractérisé par le fait qu'**il comprend des étapes au cours desquelles :
on forme une couche de protection (7) en implantant une espèce à l'interface entre, d'une part, une première couche dopée (2) et une deuxième couche dopée (3) et d'autre part la tranchée d'isolation profonde (4), l'espèce implantée ayant la propriété de créer une couche de charge négative au contact du silicium dopé.

6. Procédé selon la revendication 5, dans lequel l'espèce implantée est une espèce de type dopant p.

7. Procédé selon l'une des revendications 5 et 6, dans lequel l'espèce implantée est choisie parmi le bore et l'indium.

8. Procédé selon l'une quelconque des revendications 5 à 7, dans lequel on implante également du carbone à l'interface lors de la formation de la couche de protection (7).

9. Procédé selon l'une quelconque des revendications 5 à 8, dans lequel on co-implante au moins deux espèces différentes choisies parmi les espèces implantées.
